# EUROPÄISCHE PATENTANMELDUNG

(11) **EP 1 091 490 A2**
(43) Veröffentlichungstag der Anmeldung: **11.04.2001**
(21) Anmeldenummer: 00119070.1
(22) Anmeldetag: 02.09.2000
(51) Int. Cl.: H03K 17/06, H03K 17/0412

(54) **Ansteuervorrichtung für einen Schalter zum elektronischen Schalten eines Verbrauchers**

(30) Priorität: 06.10.1999 DE 19947921
(71) Anmelder: ROBERT BOSCH GMBH, 70442 Stuttgart (DE)
(72) Erfinder: Dittmer, Bernd, 71640 Ludwigsburg (DE); Gronbach, Roman, 70825 Korntal (DE); Rieger, Reinhard, 70372 Stuttgart (DE)

(57) **Zusammenfassung**

Die Erfindung betrifft eine Ansteuervorrichtung für einen Schalter zum elektronischen Schalten eines Verbrauchers. Der Schalter weist einen oder mehrere in Reihe zwischen einer Betriebsspannungsquelle und dem Verbraucher angeordnete Feldeffekttransistoren auf. Zur Erzeugung der Gate-Spannung der Feldeffekttransistoren ist ein mit einem Eingangsanschluß verbundener Oszillator, eine mit dem Eingangsanschluß verbundene Ladungspumpe und eine mit dem Oszillator und der Ladungspumpe verbundene Halbbrückenschaltung vorgesehen.

## Beschreibung

### Stand der Technik

Die Erfindung betrifft eine Ansteuervorrichtung für einen Schalter zum elektronischen Schalten eines Verbrauchers.

Aus der DE-A-195 48 612 ist ein elektronischer Schalter zum zeitweiligen Verbinden zweier Anschlüsse bekannt. Dieser Schalter weist wenigstens zwei elektrisch steuerbare Schaltelemente auf, die in einer Leitung zwischen den beiden Anschlüssen angeordnet sind. Wenigstens eines der elektrisch steuerbaren Schaltelemente ist ein Feldeffekttransistor oder ein anderes bidirektionales Bauelement mit externer oder integrierter Überlastabschaltung.

Ferner ist es bereits bekannt, zum elektronischen Einschalten von Verbrauchern in einem 12 V-Bordnetz Relais oder sogenannte Smart-Power-Bausteine (PROFET's) zu verwenden. Diese Bausteine haben nur einen begrenzten Spannungs- und Stromeinsatzbereich. Für höhere Betriebsspannungen ist das elektronische Schalten nur mit Leistungshalbleitern möglich. Diese Leistungshalbleiter werden mit einer Gate-Treiberstufe versehen, die das Gate schnell auflädt. Dadurch werden nachgeschaltete, im Steuergerät liegende Eingangskondensatoren ebenfalls sehr schnell aufgeladen. Bei diesem Vorgehen tritt ein Einschaltschwingen auf und damit einhergehend eine unnötig große Belastung der Gesamtschaltung.

Bei der Gate-Treiberstufe kann es sich um einen sogenannten High-Side-Schalter handeln. Derartige High-Side-Schalter sind zum Schalten von Lasten vorgesehen, die einseitig an Masse, beispielsweise an der Fahrzeugkarosserie, liegen. Dieser Schalter, bei dem es sich vorzugsweise um einen N-Kanal-Leistungs-MOSFET handelt, liegt zwischen der Betriebsspannung und der Last. Zum Einschalten benötigt er eine Gate-Spannung, die über der Versorgungsspannung von beispielsweise + 12 V liegt. Diese Gate-Spannung kann unter Verwendung einer Ladungspumpe und eines Oszillators erzeugt werden.

### Vorteile der Erfindung

Mittels der erfindungsgemäßen Ansteuervorrichtung mit den Merkmalen des Anspruchs 1 kann ein sanftes Einschalten des Verbrauchers erreicht werden. Es tritt kein Einschaltschwingen und damit auch keine unnötig große Belastung der Gesamtschaltung auf.

Durch das nur langsam erfolgende Anheben des Gatepotentials des Schalters werden die Eingangskondensatoren im Steuergerät nur langsam aufgeladen. Einschaltschwingen wird unterdrückt, da der Schalter in diesem Betriebszustand als Ladewiderstand wirkt.

In vorteilhafter Weise wird durch das oszillierende Ansteuersignal und die Verwendung einer Ladungspumpe sichergestellt, daß im Betrieb die zur Durchschaltung des Schalters notwendige Ladung auf der Gate-Elektrode der Feldeffekttransistoren erhalten bleibt.

Über das Einschaltsignal ist die Arbeitsweise der Ladungspumpe und des Oszillators derart miteinander verknüpft, daß die Oszillationen nur im Ein-Zustand auftreten. Dadurch ist sichergestellt, daß beim Ausschalten und im Aus-Zustand, d.h. bei komplett deaktivierter Ladungspumpe kein Kurzschluß der Ladungspumpe auftreten kann. Dadurch wird auch eine schädliche Belastung von Bauelementen vermieden.

In vorteilhafter Weise ist ferner sichergestellt, daß bei fehlendem Einschaltbefehl ein schnelles Sperren des Eingangsschalters erfolgt. Zu diesem Zweck wird das Gate der Feldeffekttransistoren gegenüber dem Source-Anschluß kurzgeschlossen.

Weiterhin kann durch den diskreten Aufbau der beanspruchten Vorrichtung diese auch dann eingesetzt werden, wenn hohe Eingangsspannungen vorliegen.

### Zeichnung

Nachfolgend wird die Erfindung anhand der Figuren beispielhaft näher erläutert. Die Figuren 1 und 2 zeigen Skizzen zur Erläuterung der grundsätzlichen Funktionsweise eines Schalters zum elektronischen Schalten eines Verbrauchers. In der Figur 3 ist ein Ausführungsbeispiel für eine Ansteuervorrichtung gemäß der Erfindung für einen Schalter zum elektronischen Schalten eines Verbrauchers dargestellt. Die Figur 4 zeigt ein Oszillogramm des Verlaufs der Spannungen im Steuergerät beim Einschalten der Ladungspumpe.

### Beschreibung

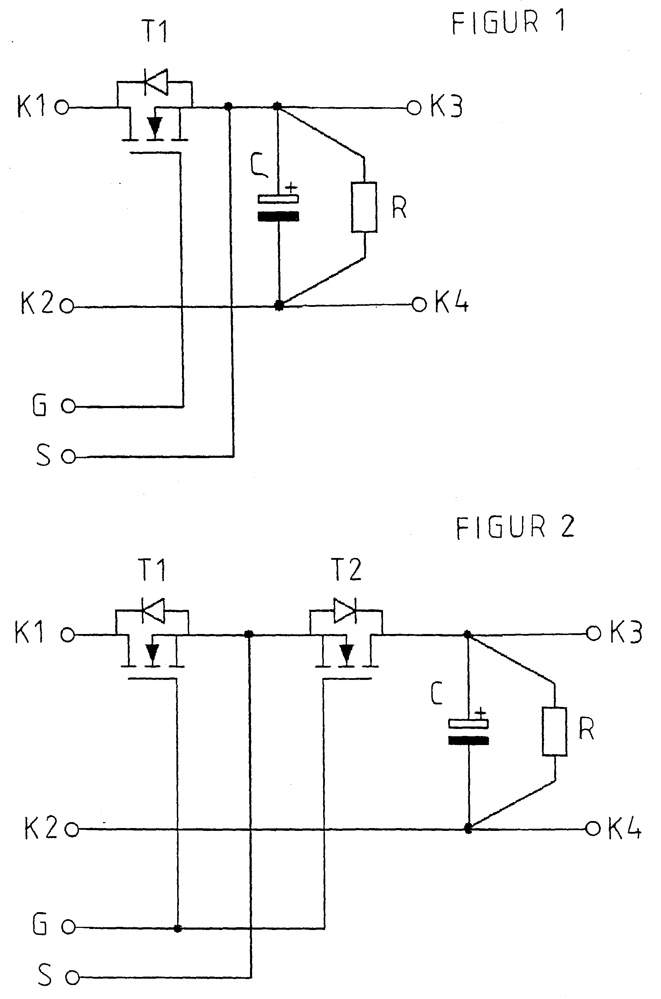

Die Figur 1 zeigt eine Skizze zur Erläuterung der grundsätzlichen Funktionsweise eines Schalters zum elektronischen Schalten eines Verbrauchers. Dieser Schaltvorgang erfolgt unter Verwendung eines Feldeffekttransistors T1 als Schalter. Der Drain-Anschluß dieses Feldeffekttransistors T1 ist mit einem Versorgungsanschluß K1 verbunden, an welchem eine Versorgungsspannung von 42 V aus dem Bordnetz eines Kraftfahrzeuges zur Verfügung steht. Diese Versorgungsspannung soll bei leitendem Schalter T1 an einen Verbraucher R weitergegeben werden, welcher an den Source-Anschluß des Feldeffekttransistors T1 angeschlossen ist. Parallel zum Verbraucher R sind Eingangskondensatoren C im Steuergerät geschaltet. Bei dem Anschluß K3 handelt es sich um eine 42 V-Klemme des Steuergerätes. Mit K2 ist die Masse des Bordnetzes und mit K4 die Masse des Steuergerätes bezeichnet.

Das Schalten des Feldeffekttransistors T1 erfolgt unter Verwendung einer Steuerspannung, die an die Gate-Elektrode G des Feldeffekttransistors T1 angelegt wird. Durch diese Steuerspannung wird das Gate im Regelfall sehr schnell aufgeladen. Die nachgeschalteten, im Steuergerät liegenden Eingangskondensatoren C werden dadurch ebenfalls sehr schnell aufgeladen. Dies kann zu einem Einschaltschwingen und damit zu einer unnötig großen Belastung der Schaltung führen.

Dasselbe gilt auch für den in der Figur 2 dargestellten Schalter zum elektronischen Schalten eines Verbrauchers. Bei dieser Ausführungsform des Schalters sind zwischen dem Versorgungsspannunganschluß K1 und dem Verbraucher R zwei Feldeffekttransistoren T1 und T2 vorgesehen, deren Source-Anschlüsse miteinander verbunden sind. Auch hier erfolgt das Schalten unter Verwendung einer an den Gate-Anschlüssen G der Feldeffekttransistoren angelegten Steuerspannung.

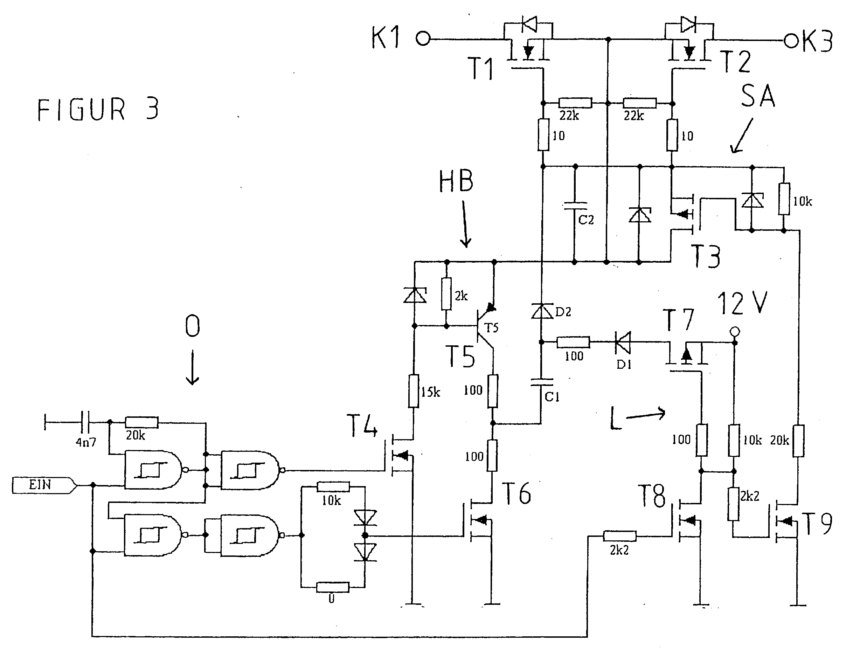

Die Figur 3 zeigt ein Ausführungsbeispiel für eine Ansteuervorrichtung gemäß der Erfindung für einen Schalter zum elektronischen Schalten eines Verbrauchers.

Auch bei diesem Ausführungsbeispiel sind zwischen der Anschlußklemme K1, an welcher eine Versorgungsspannung von 42 V zur Verfügung gestellt wird, und einer Klemme K3, an die der nicht gezeichnete Verbraucher und die Eingangskondensatoren des Steuergerätes angeschlossen sind, als Schalter zwei in Reihe geschaltete Feldeffekttransistoren T1 und T2 vorgesehen. Die Source-Anschlüsse dieser beiden Feldeffekttransistoren sind miteinander verbunden.

Zur Erzeugung der zum Schalten der Transistoren T1 und T2 erforderlichen Gate-Spannung ist eine Ansteuerschaltung vorgesehen. Diese weist einen Oszillator O, eine Halbbrückenschaltung HB, eine Ladungspumpe L und einen Schnellabschalter SA auf.

Der Oszillator O und die Ladungspumpe L sind mit einer Eingangsklemme EIN verbunden, an der der Ansteuerschaltung ein Aktivierungs- bzw. Freigabesignal zuführbar ist.

Ist ein derartiges Freigabesignal angelegt, dann beginnt der Oszillator, der in Form eines aus NAND-Gattern realisierten Schmitt-Triggers realisiert ist, zu arbeiten. Er erzeugt an seinem Ausgang bei der gegebenen Beschaltung ein Rechtecksignal mit einer Frequenz von 20 KHz. Dieses wird einmal nicht invertiert und einmal invertiert auf Schalttransistoren T4 und T6 gegeben. Der Drain-Anschluß des Transistors T4 ist mit der Basis des High-Side-Transistors T5 der Halbbrückenschaltung HB verbunden. Der Transistor T6 bildet den Low-Side-Transistor der Halbbrückenschaltung.

Das am Ausgang der Halbbrückenschaltung HB zur Verfügung gestellte Signal wird über einen Kondensator C1 und eine Diode D2 und jeweils einen Ohmschen Widerstand mit einem Widerstandswert von 10 Ohm an das Gate der Feldeffekttransistoren T1 und T2 angelegt.

Das genannte Freigabesignal wird weiterhin der Ladungspumpe L zugeführt. Diese weist zwei Feldeffekttransistoren T8 und T7 auf, wobei der Feldeffekttransistor T7 zwischen einem 12 V-Versorgungsspannungsanschluß und dem Ausgang der Ladungspumpe L angeordnet ist.

Gleichzeitig mit der Aktivierung der Ladungspumpe L wird der Schnellabschalter SA, der Feldeffekttransistoren T9 und T3 aufweist, deaktiviert und die Versorgung der Gate-Anschlüsse der Schalttransistoren T1 und T2 freigegeben. Diese Deaktivierung der Schnellabschaltung SA erfolgt unter Verwendung eines Signals, das vom Drain-Anschluß des Feldeffekttransistors T8 der Ladungspumpe dem Gate-Anschluß des Feldeffekttransistors T9 des Schnellabschalters zugeführt wird.

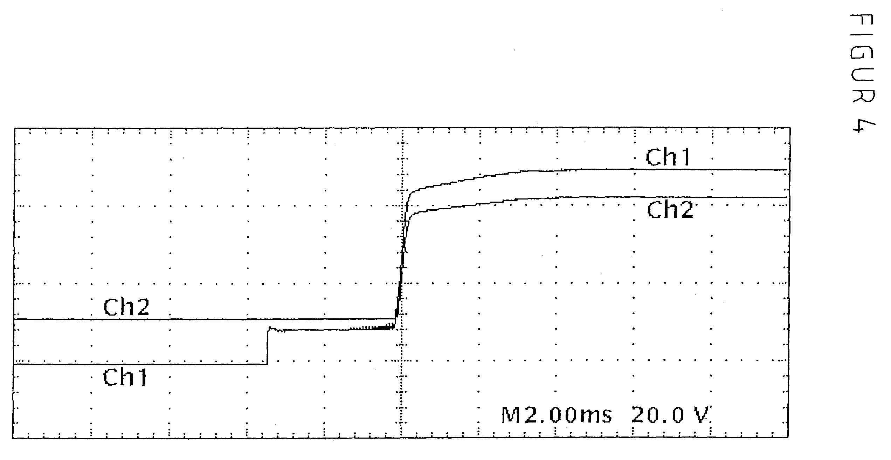

Durch den langsamen Takt der Ladungspumpe und den Lade-Vorwiderstand, der durch die Diode D1 und den in Reihe dazu angeordneten 100-Ohm-Widerstand gebildet wird, wird sichergestellt, daß die Gate-Anschlüsse der Schalttransistoren T1 und T2 nicht zu schnell aufgeladen werden. Dadurch steigt die Spannung am Ausgang des durch T1 und T2 gebildeten Eingangsschalters nur langsam auf den Wert der Eingangsspannung an. Dies ist in dem in der Figur 4 gezeigten Oszillogramm veranschaulicht. In diesem Oszillogramm ist mit Ch1 die Spannung an den Gate-Anschlüssen des Eingangsschalters und mit Ch2 die Spannung am Ausgang des Eingangsschalters bei intern vorhandener 12 V-Systemspannung gezeigt.

Durch den erzielten langsamen Anstieg des Gatepotentials der Schalttransistoren T1 und T2 liegt bezüglich der Eingangskondensatoren des Steuergerätes kein Überschwingen und damit auch keine unnötige Belastung von Bauelementen vor.

Im Betrieb selbst, d. h. bei durchlässigem Eingangsschalter T1, T2 ist die Ladungspumpe L aktiv und stellt die Ladungserhaltung auf den Gates des Eingangsschalters sicher. Durch das wechselweise Einschalten der Transistoren T5 und T6 wird am Minus-Anschluß von C1 ein springendes Potential zwischen der Systemmasse und dem Source-Anschluß der Eingangstransistoren T1 und T2 erzeugt. Dieser Source-Anschluß kann noch mit einem hochohmigen Widerstand gegenüber der Systemmasse definiert werden. Durch das genannte springende Potential wird bei aktiviertem, d. h. durchlässigem Transistor T7 der Kondensator C1 aus der 12 V-Versorgung aufgeladen und gibt anschließend einen Teil seiner Ladung über die Diode D2 auf den Kondensator C2 und somit auf die Gates der Schalttransistoren T1 und T2 ab.

Zum Deaktivieren bzw. Sperren des Eingangsschalters T1, T2 wird das Aktivierungs- bzw. Freigabesignal am Anschluß EIN weggenommen bzw. zu Null gesetzt. Dadurch wird über den Transistor T8 der Schnellabschalter SA über dessen Transistor T9 aktiviert und sorgt für ein schnelles Entladen der Gate-Anschlüsse der Feldeffekttransistoren T1 und T2. Zu diesem Zweck wird bei weggenommenen Freigabesignal am Anschluß EIN der Transistor T3 über die Transistoren T8 und T9 in den leitenden Zustand gebracht. Dadurch werden die Gate-Anschlüsse der Transistoren T1 und T2 aufgrund der niederohmigen Widerstände (10 Ohm) in den Gate-Zuleitungen gegenüber dem gemeinsamen Source-Anschluß kurzgeschlossen, d. h. entladen. Dies entspricht einem schnellen Sperren des Eingangsschalters T1, T2.

Weiterhin wird durch das Wegnehmen des Freigabesignals an der Klemme EIN die Ladungspumpe L deaktiviert, um einen Kurzschluß der Ladungspumpe über T3 zu vermeiden.

Ferner erfolgt durch ein Sperren des Transistors T7 eine Unterbrechung der Versorgung der Ladungspumpe, d. h. eine Abkopplung der Gate-Anschlüsse der Feldeffekttransistoren T1, T2 von der 12 V- Versorgungsklemme. Dadurch wird ein unkontrolliertes Wiedereinschalten der Ladungspumpe L sicher verhindert.

Nach alledem ermöglicht die erfindungsgemäße Vorrichtung ein sanftes Einschalten des Verbrauchers, um Einschaltschwingen und eine damit einhergehende unnötig große Belastung der Schaltung zu verhindern. Weiterhin wird im Betrieb die zum Durchschalten des Eingangsschalters notwendige Spannung an den Gate-Anschlüssen der Schalttransistoren T1 und T2 erhalten. Bei fehlender Freigabe erfolgt ein schnelles Abschalten und ein sicheres Sperren des Eingangsschalters. Dadurch wird eine sichere Trennung des Steuergerätes vom Bordnetz erreicht, so daß im Bordnetz keine Ruheströme auftreten.

## Patentansprüche

1. Ansteuervorrichtung für einen Schalter zum elektronischen Schalten eines Verbrauchers, wobei
der Schalter einen oder mehrere in Reihe zwischen einer Betriebsspannungsquelle und dem Verbraucher angeordnete Feldeffekttransistoren (T1, T2) aufweist, und wobei
zur Erzeugung der Gate-Spannung der Feldeffekttransistoren ein mit einem Eingangsanschluß (EIN) verbundener Oszillator (O), eine mit dem Eingangsanschluß (EIN) verbundene Ladungspumpe (T7, T8) und eine mit dem Oszillator (O) und der Ladungspumpe (T7, T8) verbundene Halbbrückenschaltung (T5, T6) vorgesehen ist.

2. Ansteuervorrichtung nach Anspruch 1, **dadurch gekennzeichnet,** daß dem Eingangsanschluß (EIN) ein Aktivierungssignal zuführbar ist.

3. Ansteuervorrichtung nach Anspruch 1 oder 2, **dadurch gekennzeichnet,** daß der Oszillator (O) ausgangsseitig mit einem ersten Schalttransistor (T4) und über einen Inverter mit einem zweiten Schalttransistor (T6) verbunden ist.

4. Ansteuervorrichtung nach Anspruch 1, **dadurch gekennzeichnet,** daß der erste Schalttransistor (T4) ausgangsseitig mit dem High-Side-Transistor (T5) der Halbbrückenschaltung verbunden ist und der zweite Schalttransistor (T6) der Low-Side-Transistor der Halbbrückenschaltung ist.

5. Ansteuervorrichtung nach einem der vorhergehenden Ansprüche, **dadurch gekennzeichnet,** daß das Ausgangssignal des High-Side-Transistors (T5) mit dem Ausgangssignal der Ladungspumpe zur Bildung der Gate-Spannung für die Feldeffekttransistoren (T1,T2) verwendet ist.

6. Ansteuervorrichtung nach einem der vorhergehenden Ansprüche, **dadurch gekennzeichnet,** daß die Ladungspumpe ein Schaltelement (T7) aufweist, welches zwischen einem Versorgungsspannungseingang (12 V) und den Gate-Anschlüssen der Feldeffekttransistoren (T1, T2) vorgesehen ist.

7. Ansteuervorrichtung nach Anspruch 6, **dadurch gekennzeichnet,** daß die Ladungspumpe hochohmig ausgelegt ist, so daß die Spannung am Gate der Feldeffekttransistoren (T1,T2) langsam ansteigt.

8. Ansteuervorrichtung nach Anspruch 7, **dadurch gekennzeichnet,** daß die Ladungspumpe ausgangsseitig eine Diode (D1) und einen mit der Diode (D1) in Reihe geschalteten Widerstand aufweist.

9. Ansteuervorrichtung nach einem der vorhergehenden Ansprüche, **dadurch gekennzeichnet,** daß die Ladungspumpe bei durchlässigem Schalter (T1, T2) zur Aufrechterhaltung der Spannung am Gate der den Schalter bildenden Feldeffekttransistoren dient.

10. Ansteuervorrichtung nach einem der vorhergehenden Ansprüche, **dadurch gekennzeichnet,** daß sie eine Schnellabschaltvorrichtung (T3,T9) aufweist.

11. Ansteuervorrichtung nach Anspruch 10, **dadurch gekennzeichnet,** daß die Schnellabschaltvorrichtung einen Feldeffekttransistor (T9) als Schalter aufweist, dessen Gate in Abhängigkeit von einem Ausgangssignal der Ladungspumpe (L) gesteuert wird.
